(19) Europäisches Patentamt
European Patent Office
Office européen des brevets

(11) **EP 0 582 171 B1**

(12) **EUROPEAN PATENT SPECIFICATION**

(45) Date of publication and mention
of the grant of the patent:
**11.12.1996 Bulletin 1996/50**

(51) Int Cl.6: **H05K 13/04**

(21) Application number: **93111932.5**

(22) Date of filing: **26.07.1993**

(54) **Method for mounting chip components and apparatus therefor**

Verfahren zum Montieren von Chip-Bauteilen und Gerät dafür

Méthode de montage de composants en forme de pastille et appareil pour cela

(84) Designated Contracting States:
**CH DE GB IT LI NL**

(30) Priority: **07.08.1992 JP 211839/92**
**13.05.1993 JP 111270/93**

(43) Date of publication of application:
**09.02.1994 Bulletin 1994/06**

(60) Divisional application: **96101597.1**

(73) Proprietor: **YAMAHA HATSUDOKI KABUSHIKI KAISHA**
**Iwata-shi Shizuoka-ken, 438 (JP)**

(72) Inventors:
• **Onodera, Hitoshi**
**Iwata-shi, Shizuoka-ken (JP)**
• **Sakurai, Hiroshi**
**Hamamatsu-shi, Shizuoka-ken (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 293 175**

• **PATENT ABSTRACTS OF JAPAN vol. 013, no. 173 (E-748)24 April 1989 & JP-A-64 002 400**

## Description

The present invention relates to a method and apparatus for mounting chip components such as electronic components like IC's etc., accurately at specified positions, specifically on the printed substrate.

The applicant has already proposed a component mounting apparatus adapted for attracting a component, such as a chip component from a component feeding section such as a tape feeder etc., by a component mounting head unit equipped with at least one attracting nozzle, transferring said component to the printed substrate disposed at a mounting position and mounting the component at the desired position on the substrate. Said apparatus provides a head unit movable in both X-axis and Y-axis directions whereas the attracting nozzle is movable in the Z-axis direction while being rotatable. Moreover, driving mechanisms are provided for transfers and movements of the mounting head as well as of the nozzle in various directions and for rotation of the nozzle, these driving means including vacuum supplying means for generating sucking vacuum at the nozzle for attracting the components are controlled by a controller section so that the chip component can be attracted and mounted automatically.

It has already been proposed that the chip component in its attracted state is detected by an optical detecting means provided on the head unit to establish a projection image of the component and to decide on the basis of the detected projection image whether the chip component is attracted normally or not so that discrepancies in the attracting position of the chip component can be recognised and overcome.

In some modification of said apparatus, it has already been proposed also that a plurality of attracting nozzles is mounted at the mounting head unit.

However, it is desirable that attracting nozzles correspond to the kind of chip components to be mounted and the most appropriate attracting nozzles among a plurality of different types of attracting nozzles having different nozzle diameters etc., be selected and installed in the head unit when the kind of chip components to be mounted changes adapting the selection of attracting nozzles to such changes correspondingly. The installation and exchange of attracting nozzles on the head unit is carried out either manually or automatically between a nozzle exchanging station and the head unit.

At such apparatus, in case where miswork or an assembling error arises while installing the attracting nozzle on the head unit, various troubles might be caused. For example, in the case where there are errors occurring in respect to the installing position of the attracting nozzle or the installing angle or there are other installing errors caused by a bend or misalignment of the attracting nozzle, the subsequent mounting procedure suffers from lacking accuracy and, for example, a decision as to whether the component has been properly attracted or not cannot be made efficiently. Moreover, in the process of installing or exchanging an attracting nozzle on the head unit a wrong attracting nozzle could erroneously be used, i.e., an attracting nozzle different from the proper one attributed to the chip component to be attracted and mounted. Such a mistake can not only be caused during manual operation but also even during automatic nozzle exchange by erroneously inputting the designation of the nozzle. In the case such a mistake is overlooked, troubles such as successive occurence of defective attractions can be caused during the subsequent mounting operation.

A method of mounting chip components according to the preamble of Claim 1 and an apparatus for mounting chip components according to the preamble of Claim 6 are known from EP-A-0 293 175.

In view of the afore-indicated deficiencies, the present invention aims to provide an improved method for mounting chip components capable of clearly distinguishing any miswork or assembling error caused while installing the attracting nozzle on a head unit of the apparatus in order to avoid difficulties from occurring in the subsequent mounting procedure.

Moreover, it is another objective to provide an improved mounting apparatus which allows mismounted or misaligned attracting nozzles disposed on a mounting head to be recognized, to attribute the proper attracting nozzle to mount a corresponding component chip and to assure a smooth mounting procedure, preferrably adapted to perform the afore-indicated method.

According to the present invention, the above-identified objective, in terms of the method aspects, is performed by the method of mounting chip components as defined in Claim 1.

Accordingly, in case of miswork or an assembling error in installing a respective attracting nozzle on the head unit, same can be detected in a preparatory stage before the main operation of the mounting process and the improper state caused by assembly faults is eliminated or an adjustment to compensate for any assembling error is made on the basis of the nozzle detection process and the decision based thereon.

Preferred embodiments of said recognizing and fault correcting preparatory steps of the mounting method according to the present invention are laid down in the further subclaims.

According to the method of the present invention and its advantageous developments, any improper installation of an attracting nozzle at the head unit is distinguished and corrected, prior to the commencement of the essential main mounting operation. Moreover, although there may occur scattering in case of potential assembling errors among the height positions of the attracting nozzles, said height positions can be properly adjusted when the chip component is subject to light radiation and is projected by an optical detecting means either during the preparatory nozzle element detecting process or during the main mounting operation by detecting and memorizing a reference height of the nozzles.

Moreover, by means of another preferred embodiment of the present method also the attracting condition of the chip component is monitored by means of detecting a projection width of the chip component under rotation about the longitudinal axis of the attracting nozzle and, therefore, improper attracting state can be discriminated and the mounting cycle can be interrupted removing the deficiency and the mounting cycle can be restarted.

Finally, even in the case there is a discrepancy and misalignment between a centre axis of the attracting nozzle and the rotation centre of the attracting nozzle while it is being rotated because of an assembling error, the rotation centre is detected and the mounting position of the related component attracted to said nozzle is accurately corrected on the basis of the detected rotation centre and a calculated correction amount.

In order to perform the above indicated objective in terms of an apparatus for mounting the chip components, according to the present invention an apparatus for mounting chip components is provided as defined in Claim 6.

Further preferred embodiments of said apparatus, according to the present invention, specifically adapted to perform the afore-indicated method are laid down in the further subclaims.

In the following, the present invention is explained in greater detail by means of several embodiments of the present invention in conjunction with the accompanying drawings:

Fig.1 is a plan view of a component mounting apparatus,
Fig.2 is a front view of the apparatus above,

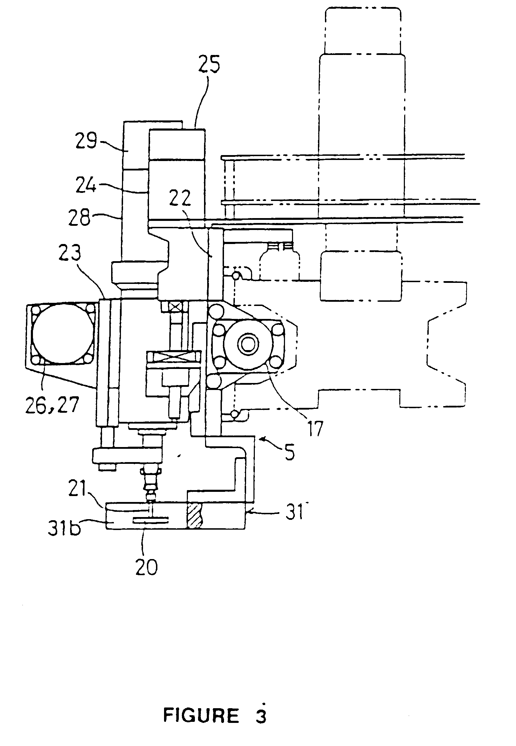

Fig.3 is an enlarged side view of a head unit for component mounting,
Fig.4 is an enlarged front view of a nozzle exchanging station,
Fig.5 is a block diagram showing a control system,
Fig.6 is a flow chart showing the exchange of the attracting nozzle and the process for deciding whether the exchange is normal of abnormal,
Fig.7(a) is an explanatory illustration showing the nozzle position while the nozzle diameter is being detected,
Fig.7(b) is an explanatory illustration showing the state of the attracting nozzle irradiated with laser beam,
Fig.8 is a flow chart showing the practical procedure for attracting and mounting components,
Fig.9 is an explanatory illustration showing the state while detecting the chip component projection width,
Figs.10(a) through 10(c) are illustrations showing attracted states of the chip component among which Fig.10(a) shows a normal state while Figs.10(b) and 10(c) show abnormal states,
Fig.11 is an illustration for showing how to obtain the mounting position correction amounts, etc.
Fig.12 is a schematic perspective view of a chip component having a special shape,
Fig.13 is part of a flow chart extracted for showing the process for deciding the attracted state in the case of a chip component having a special shape,
Fig.14 is a block diagram showing the structure of a main controller in the control system of an apparatus according to an embodiment of this invention,
Fig.15 is a flow chart showing the process as the reference nozzle height detecting means,
Figs.16(a) and 16(b) are explanatory illustrations for describing the operations in the flow chart of Fig.15,
Fig.17 is an explanatory illustration for the calculation of the recognizing height,
Fig.18 is a flow chart showing the process as the rotation center detecting means,
Fig.19 is an explanatory illustration showing the discrepancy between the rotation center and the nozzle center,
Fig.20 is an explanatory illustration showing the locus of the nozzle center and the rotation center, and
Fig.21 is an explanatory illustration showing the displacement of the nozzle center versus the nozzle rotation angle.

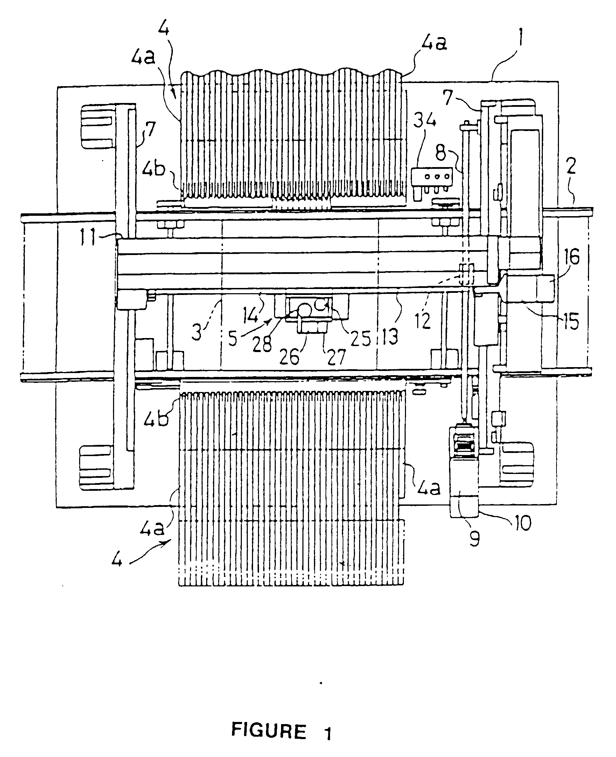

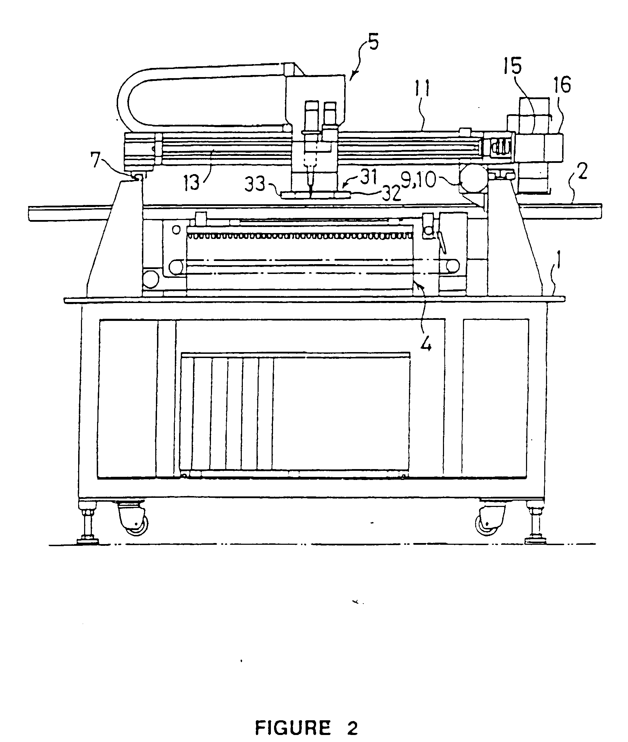

Figs.1 and 2 show the overall structure of a component mounting apparatus. As shown in these drawings, on the base 1 is disposed a conveyer 2 for conveying printed substrates 3, and the printed substrate 3 is conveyed on the conveyer 2 and is stopped at a definite position on the mounting station.

On the sides of the conveyer 2 are disposed component feeding sections 4 provided with multiple rows of feeder tapes 4a, each of which contains and holds chip components such as ICs, transisters, condensers, etc., at regular intervals and is wound round a reel. A ratchet type send-out mechanism is incorporated at the send-out end 4b of the feeder tape 4a so that the feeder tape 4a may be intermittently sent out and the pick-up operation nay be repeated as a chip component 20 is picked up from the send-out end 4b by the head unit 5.

The head unit 5 adapted for transferring both in the X axis direction (direction of the conveyer 2) and in the Y axis direction (direction perpendicular to the X axis direction on a horizontal plane) is installed above the base 1.

That is, while a pair of fixed rails 7 extended in the Y axis direction across the conveyer 2 are disposed on the base 1 in parallel with each other keeping a specified distance therebetween, a ball screw 8 to be rotated by a Y axis servomotor 9 is disposed near one fixed rail 7 as the feed mechanism in the Y axis direction. A support member 11 for supporting the head unit 5 is movably supported on both fixed rails 7, and the nut portion 12 of the support member 11 at one end thereof is in screw-engagement with the ball screw 8 so that the support member 11 may be transferred in the Y axis direction by the rotation of the ball screw 8. The Y axis servomotor 9 is provided with Y axis position detecting means 10 constituted of an encoder.

The support member 11 is, while being provided with guide rails 13 extended in the X axis direction, equipped with a ball screw 14 disposed near the guide rails 13 and an X axis servomotor 15 for rotating the ball screw 14 as an X axis direction feed mechanism. The head unit 5 is movably supported on the guide rails 13, and the nut portion 17 provided on the head unit 5 is in screw-engagement with the ball screw 14 so that the head unit 5 may be transferred in the X axis direction by the rotation of the ball screw 14. The X axis servomotor 15 is provided with X axis position detecting means 16.

The head unit 5 has attracting nozzles 21 for attracting chip components 20 installed thereon for up-down transfer and rotation. In this embodiment, the head unit 5 has a mounting member 22 supported for transfer on the guide rails 1, a head 23 installed on the mounting member 22 for up-down transfer and attracting nozzles 21 made transferrable up and down relative to the head 23 and rotatable about the R axis (nozzle center axis). The mounting member 22 is, while being provided with a nut portion 17, equipped with a head raising/lowering servomotor 24, and the head 23 is equipped with an attracting nozzle raising/lowering servomotor 26 and an attracting nozzle rotating R axis servomotor 28. The head raising/lowering servomotor 24 and the attracting nozzle raising/lowering servomotor 26 constitute up-down driving means for the attracting nozzle, and the R-axis servomotor 28 constitutes rotation driving means.

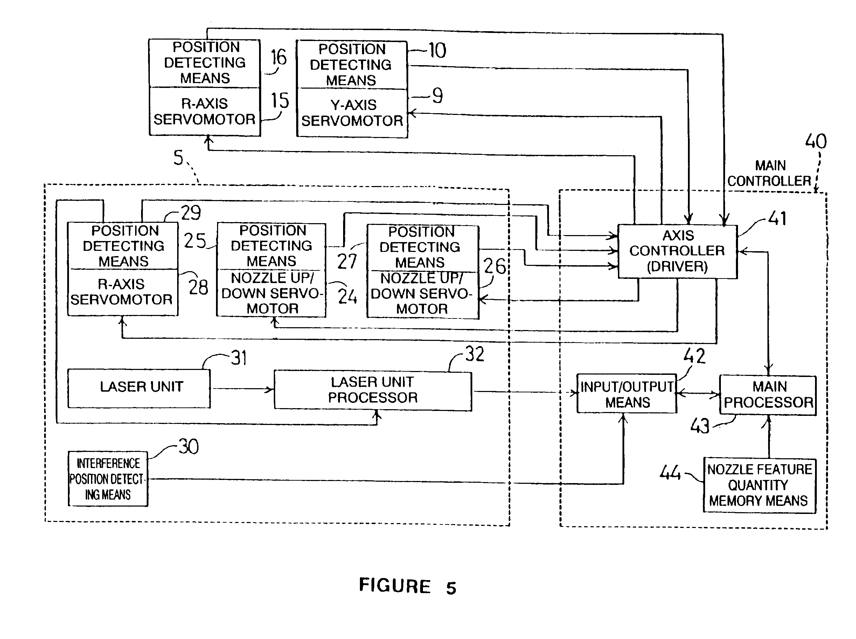

The servomotors 24, 26 and 28 are provided with position detecting means 25, 27 and 29 respectively. Further, interference position detecting means (See Fig.5) for detecting the interference position of the attracting nozzle 21 with the component feeding section 4 is installed on the head unit 5.

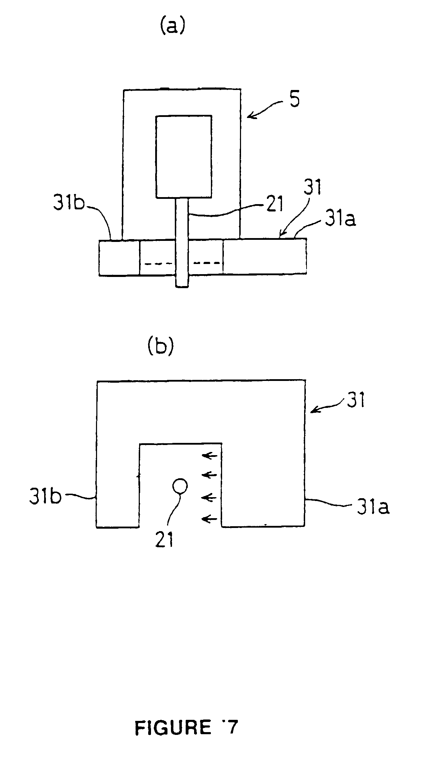

On the lower end portion of the head unit 5 is installed a laser unit 31 constituting optical detecting means. This laser unit 31 serves both as means for detecting the nozzle diameter described later and as means for detecting the projection width of a chip component, and has a laser beam producing portion (parallel ray emitting portion) 31a and a detector (ray receiving portion) 31b facing each other with an attracting nozzle positioned therebetween (See Fig. 7). The detector 31b is constituted of a CCD.

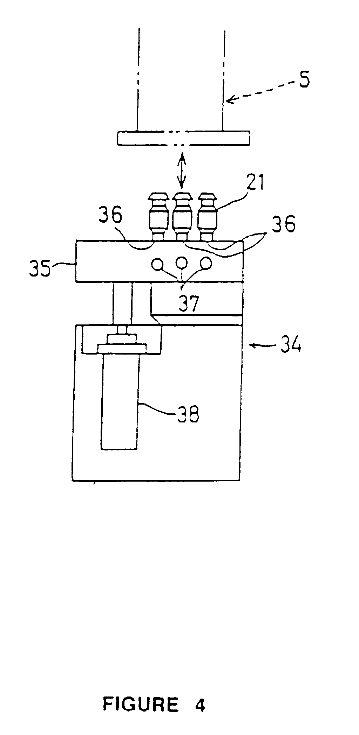

At a suitable position within the moving range of the head unit 5 on the base 1 is installed a nozzle exchange station 34 which, as shown in Fig.4, is provided with a nozzle clamp plate 35, a nozzle holding portion 36 disposed on the plate 35 to releasably hold a plurality of kinds of attracting nozzles 21 having different external form feature quantities such as nozzle diameters, etc., nozzle distinguishing sensors 37 for distinguishing the existence of the nozzles, raising /lowering cylinder 38, etc. When exchanging attracting nozzles, the head unit 5 is transferred to the position corresponding to this nozzle exchanging station 34 so that the attracting nozzles 21 may be exchanged between both.

Fig.5 shows an embodiment of the control system in which the servomotors 9, 15, 24, 26 and 28 for the X direction transfer, for the Y direction transfer, for raising/lowering the head on the head unit, for raising/lowering attracting nozzles and for rotation about the R axis, respectively, and position detecting means 10, 16, 25, 27 and 29 respectively for the sevomotors above are electrically connected to the axis controller (driver) 41 of the main controller 40. The laser unit 31 is electrically connected to the laser unit processor 32 which is in turn connected to the main processor 43 through the input/output means 42 of the main processor 43. Further, the interference position detecting means 30 is connected to the input/output means 32. The main controller 40 is provided with nozzle feature quantity memory means 44 which stores the external feature quantities corresponding to the kind of the attracting nozzles 21, more practically saying, stores a table of the nozzle diameter corresponding to the kinds of the attracting nozzles 21.

The main processor 43 carries out various processing operation required for attracting and mounting chip components during the main operation for attracting from the component feeding section 4 and mounting chip components on the printed substrate 3 at the predetermined positions by the head unit 5, while, on the stage of the preparatory operation for installing the attracting nozzle 21 on the head unit 5, carries out nozzle element detecting operation for detecting the elements representing the form or position of the attracting nozzle installed on the head unit and deciding or setting operations for the attracting nozzle on the basis of this nozzle element detecting operation. In this case, as the nozzle element detecting operation in the preparatory operation, the external feature quantities of the attracting nozzle 21 installed on the head unit 5 (practically, the nozzle diameter) is detected by the laser unit 31, and decides whether the attracting nozzle is a proper one or not by comparing the detected value with the nozzle diameter of the proper attracting nozzle (attracting nozzle to be selected according to the kind of the chip component 20 to be attracted and mounted) read out of the nozzle feature quantity memory means 44. Thus, the main processor 43 constitutes comparing deciding means.

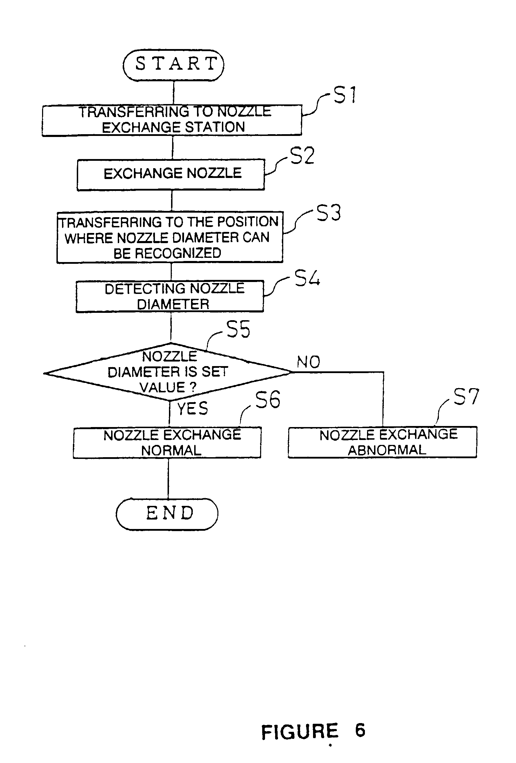

Fig.6 shows the process for exchanging the attracting nozzle 21 and deciding whether the exchanged nozzle is proper or not on the preparatory stage for attracting and mounting components as a flow chart. The operation in this flow chart is described referring to operation explanatory illustrations of Figs.7(a) and 7(b).

In this operation, first the head unit 5 is transferred to the nozzle exchange station 34 at the step S1, and the nozzle is exchanged at the next step S2. Then, the attracting nozzle 21 is transferred to the position at which the nozzle diameter can be recognized at the step S3, that is, into the state in which the portion of the attracting nozzle near the tip end thereof corresponds to the laser unit 31.

In this state, the nozzle diameter is detected by the laser unit 31 (step S4). That is, as shown in Fig.7(b), laser beam (arrow mark) is emitted from the laser generator 31a, and the projection width of the attracting nozzle, i.e., the nozzle diameter of the attracting nozzle, is detected by the detector 31b receiving the laser beam.

At the next step S5, the detected value above of the nozzle diameter is compared with the set value for the proper attracting nozzle read out of the nozzle feature quantity memory means 44, and the nozzle exchanged is decided to be normal when the detected nozzle diameter is equal to the set value (step S6) or to be abnormal when the detected nozzle diameter is not equal to the set value (step S7). When the exchanged nozzle is found abnormal, the abnormality will be indicated by a pilot lamp, etc., and the attracting and mounting operations thereafter will be suspended.

In the case where an improper attracting nozzle is installed by mistake when exchanging the attracting nozzle, this exchange abnormality is made clear by the process shown in this flow chart.

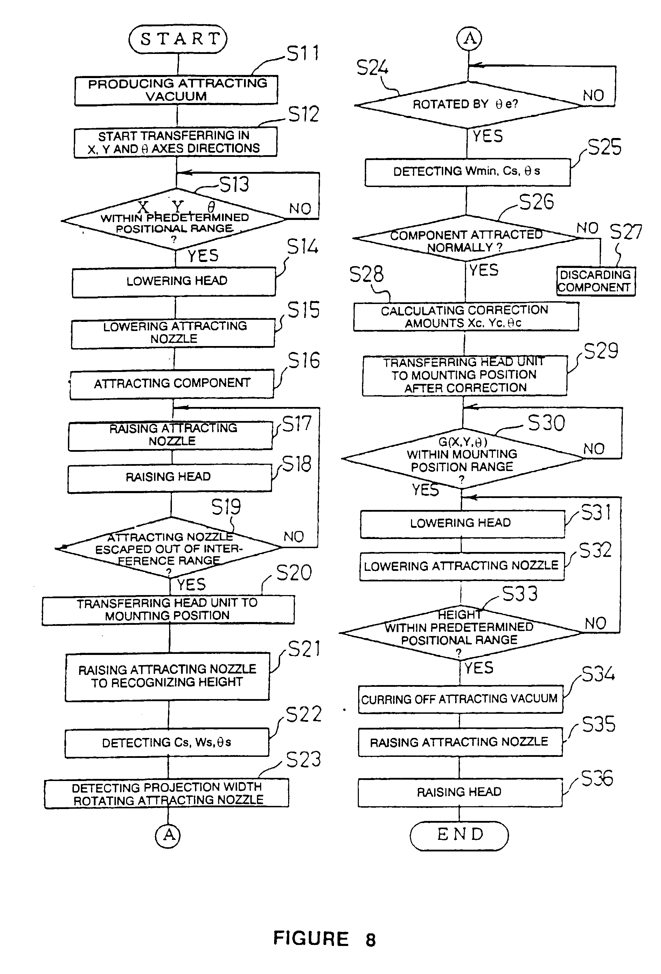

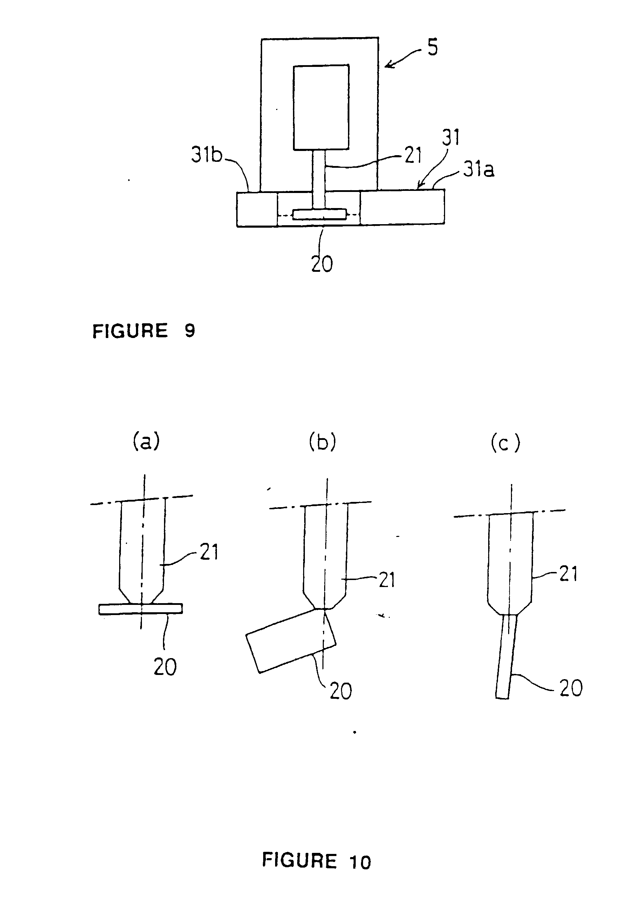

Fig.8 shows a series of processes from attraction to mounting of a chip component after the processes on the preparatory stage described above as a flow chart including processes for correcting errors caused by scattering of the position and direction of the chip component at the attraction. The processes in this flow chart is described hereafter also referring to Figs.9 through 11.

While the attracting nozzle 21 ia supplied with attracting vacuum by vacuum producing means not shown here at the first step S11, it is transferred in the X axis and Y axis directions and its rotation about the $\theta$ axis are started by actuating respective servomotors at the step S12. At the step S13, it is examined in succession whether the center coordinates (X, Y and $\theta$) of the attracting nozzle 21 have come into the positional range predetermined for attraction. When having come into the predetermined positional range, the head unit 23 is lowered at the step S14, the attracting nozzle 21 is also lowered at the step S15, a chip component 20 is attracted to the attracting nozzle 21 from the feeder tape 4a of the component feeding section 4 at the step S16, then the attracting nozzle 21 is raised at the step S17, and also the head 23 is raised at the step S18.

At the step S19, it is examined whether the attracting nozzle 21 has reached a height for escaping out of the range of its interference with the component feeding section 4, and the steps S17 through 19 are repeated while it does not reach the height above. When has escaped out of the range of its interference, the head unit 5 is transferred to the component mounting position at the step S20, and the attracting nozzle 21 is raised to the chip component recognizing height at the step S21, that is, to the height at which the chip component corresponds to the laser unit 31 as shown in Fig.9. In this state, while the attracted state of the chip component is examined, processes for obtaining mounting position correction amounts (steps S22 through S28) are carried out. To assure the detection of the minimum projection width (described later), etc., it is preferrable to preliminarily rotate the attracting nozzle 21 prior to the step S22 in a sense contrary to that of the rotation for detection.

At the step S22, the projection width $W_s$, center'position $C_s$ and the rotation angle $\theta_s$ at that time are detected. At the step S23, the component projection width is detected i succession-while rotating the attracting nozzle 21 in a predetermined sense. When it is decided that the attracting nozzle 21 has been rotated by a definite rotating angle $\theta_e$ at the step S24, the minimum value $W_{min}$ of the projection width, the center position $C_m$ and the rotation angle $\theta_m$ at the minimum projection width are read in at the step S25. Then, it is decided at the step 26 whether the component attraction is normal or not on the basis of the detected data, the component is discarded at the step S27 if not normal and the mounting position correction amounts $X_c$, $Y_c$ and $\theta_c$ in the X, Y and $\theta$ directions, respectively, are calculated on the basis of the detected data at the step S28.

At the step S26 above, it is decided whether the chip component is attracted normally as shown in Fig.10(a) or abnormally in erected states as shown in Figs.10(b) and 10(c). Practically, it is examined whether the following equations hold or not, and the attracted state is decided to be abnormal if any one of following equations holds. The value $\alpha$ in the equations is a safety factor.

$$[\text{eq. 1}] \qquad W_{min} < (\text{length of shorter side of component}) \times (1-\alpha)$$

$$W_{min} > (\text{length of longer side of component}) \times (1+\alpha)$$

$$\theta_m = \theta_s$$

$$\theta_m = \theta_e$$

The correction amounts $X_c$, $Y_c$ and $\theta_c$ is calculated at the step S28 as follows:

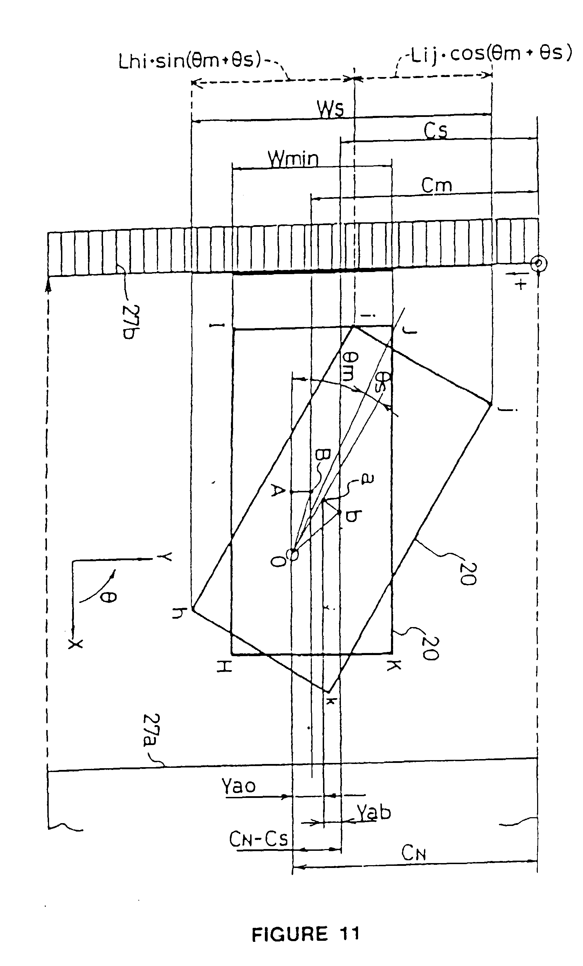

As is clearly seen in Fig.11, when the chip component 20 is attracted in a state with its longer side directed in the X axis direction, the correction amounts $Y_c$ in the Y axis direction and $\theta_c$ in the $\theta$ direction among the component mounting position correction amounts $X_c$, $Y_c$ and $\theta_c$ are given by:

[eq. 2] $Y_c = C_m - C_N$, and

$$\theta_c = \theta_m.$$

where $C_N$ represents the center position (attracting point) of the attracting nozzle, and is a known value.

In Fig.11, 0 is the center point of the attracting nozzle, b and B are chip component center points in the initial state and in the minimum projection width state, respectively, and $\Delta a0b \equiv \Delta A0B$.

When taken as follows:

$L_{AB}$ : length of the segment AB,
$L_{ab}$ : length of the segment ab,
$L_{AO}$ : length of the segment AO,
$L_{aO}$ : length of the segment aO,
$Y_{ab}$ : projection length of the segment ab on the Y axis, and
$Y_{aO}$ : projection length of the segment aO on the Y axis,

$$[eq.\ 3] \qquad C_N - C_S = Y_{aO} + Y_{ab},$$

$$[eq.\ 4] \qquad Y_{aO} = L_{aO} \cdot \sin(\theta_m + \theta_s),\ and$$

$$[eq.\ 5] \qquad Y_{ab} = L_{ab} \cdot \cos(\theta_m + \theta_s).$$

Since $L_{aO} = L_{AO} = X_c$, and $L_{ab} = L_{AB} = C_N - C_m$, $X_c$ is derived from the equations above as shown in the following equation:

$$[eq.\ 6] \qquad X_c = \{(C_N - C_s) - (C_N - C_m) \cdot \cos(\theta_m + \theta_s)\}/\sin(\theta_m + \theta_s).$$

When the calculation at the step S28 is completed, the head unit 5 is transferred to the corrected component mounting position at the step S29, and it is decided at the step S30 whether the center coordinate $G(X, Y, \theta)$ of the chip component has reached the mounting position range on the printed substrate 3 or not. If reached, the head 23 is lowered at the step S31, the attracting nozzle 21 is also lowered at the step S32, then, when the height of the attracting nozzle 21 has reached the predetermined height range at the step S33, the vacuum is cut off at the step S34 to mount the chip component 20 on the printed substrate 3. Thereafter, the attracting nozzle 21 is raised at the step S35, and the head 23 is also raised at the step S36.

According to the method as shown in the flow chart of Fig.8, while the chip component 20 is attracted and mounted on the printed substrate 3, even if errors of direction and position of the chip component 20 are caused by scattering thereof, correction amounts corresponding to the errors are obtained in the processes at the steps S21 through S28 and the mounting position is corrected accordingly, and the chip component 20 is mounted accurately.

Since these operations are carried out while the chip component is being transferred to the mounting position after attraction, a series of operations from attraction to mounting are carried out efficiently.

Further, since the attracting nozzle 21 and the head 23 holding the nozzle 21 are both raised and lowered by respective servomotors 24 and 26, lowering (steps S14 and S15) and raising (steps S17 and S18) for attraction and lowering (steps S31 and S32) and raising (steps S34 and S35) for mounting are speeded up, which further improves the work efficiency.

At the step S26 of the flow chart of Fig.8, it is decided whether the component attraction is normal or not for a usual chip component 20 having its length of the shorter side different from its thickness, and the chip component attraction is decided to be normal if the minimum value of the projection width $W_{min}$ is nearly equal to the length of the shorter side.

However, among various chip components 20, there may be special shape chip components 20 having its length of the shorter side and its thickness nearly equal to each other. When such a component is used, even if the minimum value of the projection width is examined, it is impossible to distinguish the abnormal case where the component is erected making the thickness t be regarded as the minimum value $W_{min}$ of the projection width from the normal case where the shorter side length I becomes the minimum value $W_{min}$ of the projection width.

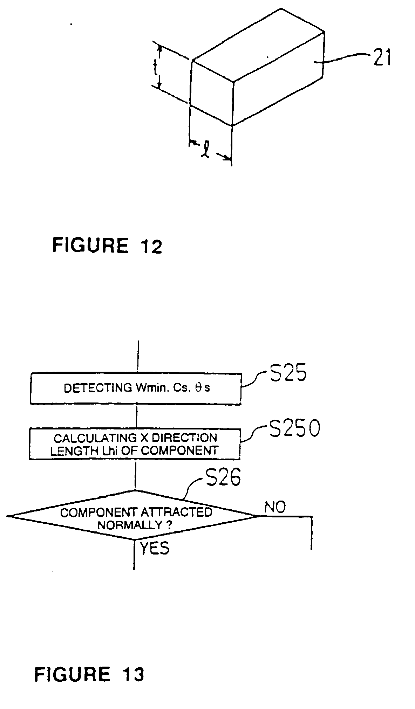

As a measure to such cases, it will do to modify part of the method shown in Fig.8 as shown in Fig.13. That is, a step S250 for calculating the X direction length $L_{hi}$ of the component 20 is inserted between the steps S25 and S26, it is decided at the step S26 whether the component attraction is normal or not using the length $L_{hi}$, then the processes of the step S27 or the steps S28 and thereafter are carried out.

The X direction length $L_{hi}$ of the component 20 is calculated at the step S250 as follows:

Taking, in Fig.11,

$L_{hi} (= L_{HI})$:    X direction length of the component (length of the line segment hi equal to the length of the line segment HI), and

$L_{ij} (= L_{IJ})$:    length of the line segment ij (length of the line segment IJ),

$W_s$ is given by:

$$[eq.\ 7] \qquad W_s = L_{hi} \cdot \sin(\theta_m + \theta_s) + L_{ij} \cdot \cos(\theta_m + \theta_s)$$

as shown in Fig.11. Since $L_{ij} = L_{IJ} = W_{min}$, the X direction length of the component $L_{hi}$ is obtained by

$$[eq.\ 8] \qquad L_{hi} = \{(W_s - W_{min} \cdot \cos(\theta_m + \theta_s)\}/\sin(\theta_m + \theta_s).$$

Since this X direction length $L_{hi}$ of the component obtained above is to be the length of the longer side of the component if the component is attracted normally, in addition to the conditions in the decision at the step S26, if

$$[eq.\ 9] \qquad L_{hi} < (\text{longer side length of the component}) \times (1 - \beta),\ \text{or}$$

$$L_{hi} > (\text{longer side length of the component}) \times (1 + \beta),$$

where $\beta$ is a safety factor, the component attraction is decided abnormal.

Although the laser unit 31 installed on the lower end portion of the head unit 5 is utilized both for detecting the nozzle diameter and for detecting the chip component projection width for mounting position correction to simplify the structure, another optical detecting means for detecting the nozzle diameter may be equipped separately from the optical detecting means for detecting the chip component projection width. In this case, the optical detecting means for detecting the nozzle diameter may be so equipped fixedly near the nozzle exchanging station that the nozzle diameter may be detected with the head unit 5 transferred to this position.

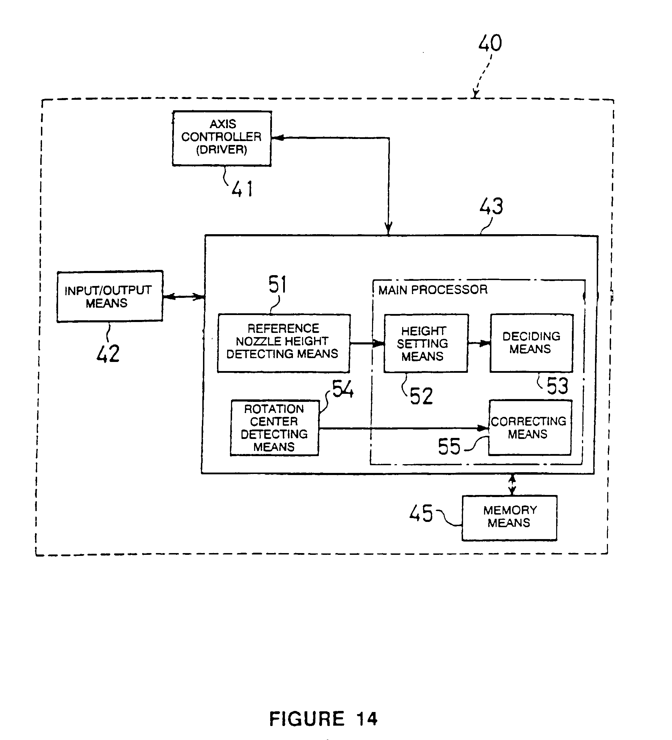

Fig.14 shows a main controller 40 in the control system for a component mounting apparatus according to an embodiment of this invention. Although omitted in Fig.14, various servomotors, position detecting means, laser unit processor, etc., to be connected to this main controller 40 are similar to those shown in Fig.5.

The main controller 40 above is provided, while being provided with an axis controller 41, input/output means 42 and main processor 43, with memory means 45.

The main processor 43 carries out various calculation processes required for the attracting and mounting operations for the chip components 20 as controls for the main operation of the component mounting apparatus. Further, the main processor 43 constitutes reference nozzle height detecting means 51 by, as nozzle element detecting process and the process based thereon in the preparatory operation stage, detecting the reference nozzle height which is the nozzle height obtained when the attracting nozzle tip end is brought to a position corresponding to the laser unit 31 by raising/lowering the attracting nozzle 21 and storing this height in the memory means 45. Further, it constitutes height setting means 52 by, when deciding the chip component attraction state by the deciding means 53 on the basis of the detection of the projection image of the chip component made by the laser unit after the chip component attraction during the main operation, setting the height position of the attracting nozzle on the basis of the reference nozzle height.

Further, the main processor 43 constitutes rotation center detecting means 54 by detecting, on the basis of the data obtained when detecting the projection image of the attracting nozzle by the laser unit 31 while rotating the attracting nozzle 21 on the preparatory operation stage, and storing the rotation center of the attracting nozzle 21 in the memory means 45, while it constitutes correcting means by obtaining the discrepancies of the attracted position of the chip component on the basis of the data of the projection width of the chip component 20 obtained by the laser unit 31 while rotating the attracting nozzle 21 after chip component attraction in the main operation, and calculating the mounting position correction amounts coorresponding to the discrepancies above.

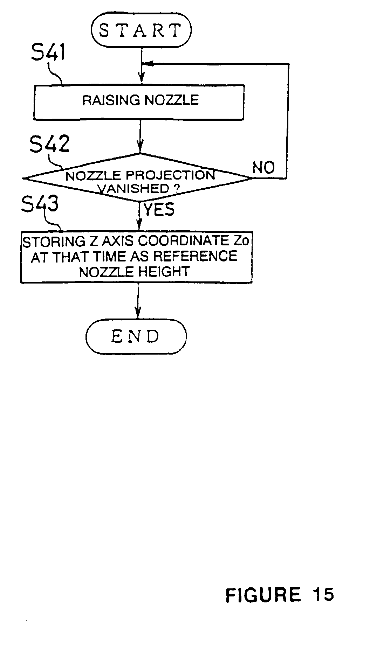

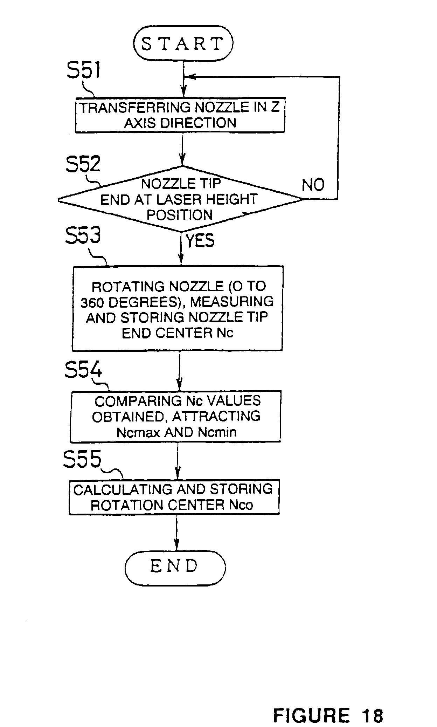

On this embodiment system, after the attracting nozzle 21 is installed on the head unit 5, the function as the reference nozzle height detecting means 51 is carried out by the process shown in Fig.15, and the function as the rotation center detecting means 54 is carried out by the process shown in Fig.18. Although the control during the main operation is carried out as shown in the flow chart of Fig.8, the reference nozzle height detected by the reference nozzle height detecting means 51 and the rotation center detected by the rotation center detecting means 54 are used in the process of the steps S21 through S28 in this flow chart.

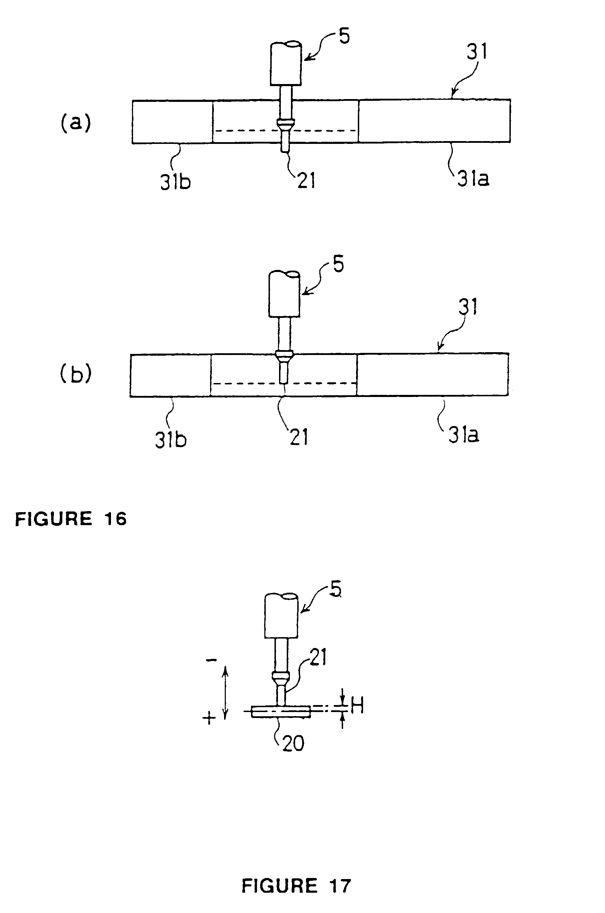

These processes are described hereafter referring to Figs.16, 17 and 19 through 21.

In the process of the reference nozzle height detecting means 51 shown in the flow chart of Fig.15, after installed on the head unit 5, the attracting nozzle 21 is raised at the step S41 from the state at the lowered position shown in Fig.16(a) by actuating the nozzle raising/lowering means such as the nozzle raising/lowering servomotor 26 or the like for raising/lowering the attracting nozzle 21 relative to the head unit 5 in the Z axis direction. At the next step S42, the projection of the attracting nozzle 21 is detected by the laser unit 31 and it is decided whether this projection of the attracting nozzle 21 has vanished or not. While the tip end of the attracting nozzle 21 is lower than the laser beam (shown in a broken line in Fig.16) emitting position, since the projection of the attracting nozzle 21 is detected and the decision at the step S42 is "NO", the program is returned to the step S41 to continue raising the attracting nozzle 21.

When the attracting nozzle 21 is raised to the position shown in Fig.16(b), namely to the position at which the tip end of the attracting nozzle 21 passes the laser emitting position of the laser unit 31, the laser beam begins not to be intercepted by the attracting nozzle 21 to make the decision at the step S42 "YES", and the procedure proceeds to the step S43 to store the Z axis coordinate $Z_o$ at that time in the memory means 45 as the reference nozzle height.

The reference nozzle height $Z_o$ is used for setting the recognizing height in the process (step S21) for raising the attracting nozzle 21 up to the recognizing height to decide the component attracting state, etc., on the basis of the detection of the projection of the chip component 20 in the process of the main operation shown in the flow chart of Fig.8. That is, taking the height from the upper end attracted surface of the chip component 20 to its region suitable for component recognition as H (See Fig.17), the recognizing height at the step S21 is determined as $[Z_o - H]$ from the height H and the reference nozzle height $Z_o$ above (provided that the downward direction is positive for the Z axis), and the attracting nozzle 21 is raised up to this height.

By such operations, the processes of the steps S22 through S28 are carried out correctly. That is, although a value preset according to the kind, etc., of the attracting nozzle cam be used for setting the recognizing height, if only the preset value is used, the laser irradiating position of the chip component may be shifted from the proper position in the case where some scattering is caused in the nozzle height by an assembly error or the like. On the contrary, in this embodiment, the recognizing height is correctly adjusted by setting the recognizing height on the basis of the reference nozzle height $Z_o$ detected in the preparatory stage even if scattering of the reference nozzle height $Z_o$ is caused by assembly error, and processes of projection width detection and decision based thereon (step S26), correction (step S28), etc., will be carried out correctly.

Further, in the process of the rotation center detecting means 54 shown in the flow chart of Fig.18, the attracting nozzle 21 is raised/lowered in the Z axis direction (steps S51 and S52) by actuating the raising/lowering means until the tip end portion of the attracting nozzle 21 reaches the height position corresponding to the laser emitting position of the laser unit 31. Then, when the height position above is reached, while the attracting nozzle is rotated from 0 to 360 degrees by actuating the R axis servomotor 28 as rotation driving means, the center value of the attracting nozzle 21 is measured on the basis of the detection of the projection of the attracting nozzle 21 made by the laser unit 31, and is temporarily stored in the register (step S53).

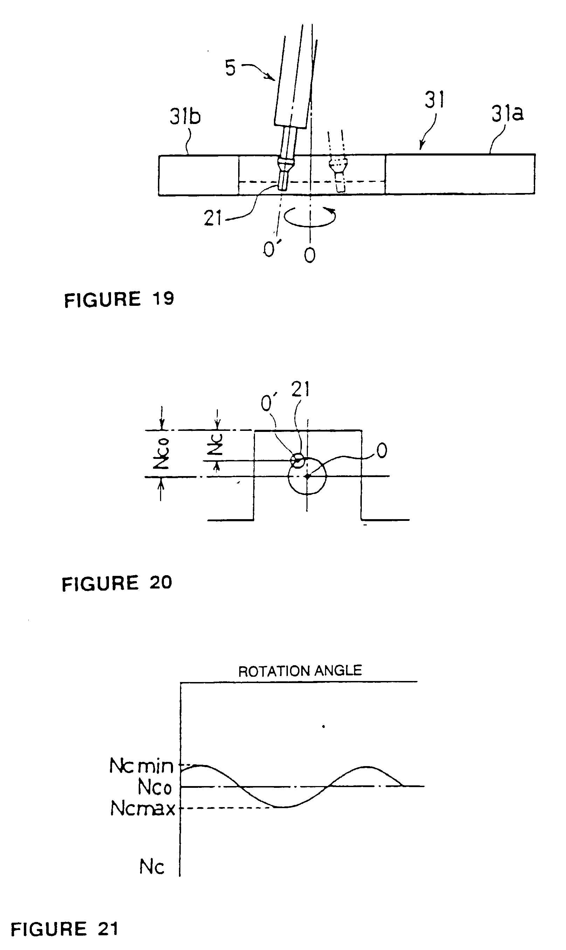

In this case, if the attracting nozzle 21 is installed obliquely relative to the R axis or if it is bent, the center 0' of the attracting nozzle does not coincide with the rotation center 0, and, if the attracting nozzle 21 is rotated in this state, the nozzle center 0' is moved circularly as shown in Fig.20, and the nozzle center 0' moves as shown in Fig.20 and the change of the nozzle center position in relation to the rotation angle becomes wavy as shown in Fig.21.

Therefore, at the step S54, the values of the nozzle center positions $N_c$ detected while the attracting nozzle 21 is once rotated are compared with one another, their minumum and maximum values $N_{cmin}$ and $N_{cmax}$ are abstracted, then, at the step S55, the rotation center of the attracting nozzle $N_{co}$ is calculated as follow:

$$[eq.10] \; N_{co} = (N_{cmin} + N_{cmax})/2.$$

This rotation center $N_{co}$ is used in the process (step S28) as the correcting means for obtaining the component mounting position correction amounts $X_c$, $Y_c$ and $\theta_c$ on the basis of the detection of the projection of the chip component 20 in the process of main operation shown in the flow chart of Fig.8. Practically, while the correction amounts $X_c$, $Y_c$ and $\theta_c$ are obtained by the calculating equations [eq. 2] through [eq. 6] above, $C_N$ included in the calculating equations is made the rotation center $N_{co}$ above, that is, in this embodiment, the calculations of the correction amounts $X_c$, $Y_c$ and $\theta_c$ are calculated by the calculating equations [eq. 2] through [eq. 6] after $C_N$ included in the calculating equations is made $N_{co}$, that is, after $C_N$ is substituted by $N_{co}$ as $C_N = N_{co}$.

By such calculations, the accuracy of the component mounting position correction is improved. That is, even in the case where there is some discrepancy between the nozzle rotation center 0 and the nozzle center 0' because of the inclination of the attracting nozzle 21 caused by assembly error or because of the nozzle bend, the rotation center $N_{co}$ of the attracting nozzle 21 is correctly obtained by the process as the rotation center detecting means 54 on the preparatory stage, and the discrepancy between the nozzle rotation center 0 and the chip component attracting position and the correction amount therefor will be detected correctly on the basis of this value $N_{co}$ by the process as the correcting means at the step S28.

Although the example shown in Fig.14 is adapted for detecting the reference nozzle height and the nozzle rotation center by the reference nozzle height detecting means 51 and the rotation center detecting means 54, respectively, in the preparatory stage, only either of them may be detected in the preparatory stage according to the requirement.

It is to be noted that the case of exclusively detecting the reference nozzle height in the preparatory stage is not claimed by present claim 1.

Further, the decision whether the proper attracting nozzle 21 is installed or not on the basis of the nozzle diameter detection as shown above the detection of the reference nozzle height and the detection of the nozzle rotation center may be carried out collectively in the preparatory stage.

According to the component mounting method of described above since the nozzle elements detecting process for detecting the elements representing the form or position of the attracting nozzle installed on the head unit is carried out after the attracting nozzle is installed on the head unit in the preparatory operation, and the deciding or setting process for the attracting nozzle is carried out on the basis of this nozzle elements detecting process, even in the case where there was miswork or assembly error when installing the attracting nozzle on the head unit, decision or adjustment for them can be made appropriately and various trouble caused by the miswork, etc., above can be prevented.

Moreover, according to the component mounting method described above and the apparatus for embodying this method, since the external form feature quantities of the attracting nozzle installed on the head unit are detected on the preparatory stage, and it is decided thereon whether the attracting nozzle installed is a proper one or not, even in the case where an improper attracting nozzle is installed on the head unit, it is possible to distinguish it from the proper one, and troubles such as defective attraction caused by using an improper attracting nozzle can be prevented.

Further, according to the component mounting method described above and the apparatus for embodying this method, since the reference nozzle height at which the tip end of the attracting nozzle is brought to the position corresponding to the optical detecting means is detected and stored after the attracting nozzle is installed, and the attracting nozzle is adjusted to the height obtained on the basis of the reference nozzle height above when detecting the projection of the chip component by the optical detecting means in the main operation, even if there is scattering in the attracting nozzle height positions because of assembly error, etc., the detection of the projection of the chip component made by the optical detecting means and the decision of the chip component attracted state based thereon can be carried out accurately.

In this method, if the projection width of the chip component is measured while rotating the nozzle attracting the chip component thereto within a definite rotational range to obtain the minimum projection width, maximum projection width and the rotation angle corresponding to the minimum projection width, and it is decided that the chip component attracted state is defective in any of the cases where the projection width minimum value is smaller than the lower limit side reference value, where the projection width maximum value is larger than the upper limit side reference value and where the rotation angle corresponding to the minimum projetion width does not exist within the definite rotation range above as the process for deciding the chip component attracted state, the chip component attracted state can be decided accurately.

Further, according to the component mounting method described above and the apparatus for embodying this method, since the rotation center of the attracting nozzle is detected and stored after the attracting nozzle is installed and, in the main operation thereafter, the discrepancy of the attracted position of the chip component is obtained on the basis of the projection of the chip component detected by the optical detecting means while rotating the attracting nozzle and the rotation center above, the component mounting position can be corrected accurately.

## Claims

1. Method of mounting chip components (20) at specific positions, preferably on a substrate such as a printed circuit board, comprising a main operation including the steps of at tracting a component (20) through an attracting nozzle (21) associated with a movable head unit (5) from a component supply unit (4), transferring the chip component (20) and mounting the same at the desired position, and a preparatory nozzle detecting process preceding the main mounting operation and using an optical detecting means (31) for detecting whether or not the attracting nozzle (21) has a shape and/or a position adapted to the chip component to be mounted, **characterised in that**, in the preparatory nozzle detecting process, the attracting nozzle (21) is rotated in a detection area of said optical detecting means (31) for obtaining projection data ($N_c$) of the attracting nozzle (21) while rotating the nozzle, wherein a rotation center ($N_{co}$) of the attracting nozzle (21) is determined on the basis of said projection data ($N_c$) and wherein, in the subsequent main mounting operation, correction values for the component mounting position are determined using said rotation center ($N_{co}$) as the center position ($C_N$) of the attracting nozzle (21).

2. Method as claimed in claim 1, **characterised in that** the shape and/or position of the attracting nozzle (21), which is installed on the head unit (5) comprise external shape feature values adjusted to the shape of the chip component (21) to be mounted, wherein it is decided whether a certain attracting nozzle (21) installed is a proper one or not by comparing the detecting value of the external shape feature values with a set value indicative for the proper attracting nozzle (21).

3. Method as claimed in claim 1 or 2, **characterised in that** a reference nozzle height, which is a nozzle height obtained when a tip end of the attracting nozzle (21) is brought to a position corresponding to the optical detecting means (31) disposed on the head unit (5) by raising or lowering the attracting nozzle (21), is detected, wherein said reference height is stored as a setting process based on the detection of the reference height of the respective attracting nozzle (21) and, in the subsequent main mounting operation thereafter, in a state with the attracting nozzle (21) having a chip component (20) attracted thereto and brought to a height obtained on the basis of said reference nozzle height, a projection width ($W_s$) of the chip component (21) is detected by said optical detecting means (31) and the state of chip attraction to the attracting nozzle (21) is decided on the basis of the detected projection width ($W_s$) of the chip component (20).

4. Method as claimed in claim 3, **characterised in that**, as a process for deciding on the attracted state of the chip component (20), the projection width ($W_s$) of the chip component (20) is measured while rotating the chip component by a definite rotation angle range ($\theta_e$), detecting a projection width minimum value ($W_{min}$) of the chip component (20) attracted to the attracting nozzle (21) and the rotation angle ($\theta_m$) corresponding to the minimum value of the projection width ($W_{min}$), evaluating the attracted state of the chip component (20) to be defective either when the projection width minimum value ($W_{min}$) is smaller than a lower limit reference value which is set smaller by a predetermined amount than the shorter side of the chip component (20), and/or when the projection width minimum value ($W_{min}$) is larger than a higher limit reference value which is set larger by a predetermined amount than the longer side of the chip component (20), and/or when the rotation angle ($\theta_m$) corresponding to the projection width minimum value ($W_{min}$) is outside the predetermined definite rotation angle range ($\theta_e$).

5. Method as claimed in at least one of the preceding claims 1 to 4, wherein the rotation centre (O) of the attracting nozzle (21) is stored and wherein the correction values of the mounting position of the chip component in the subsequent main process thereafter are obtained on the basis of the projection of the chip component (20) detected by the optical detecting means (31) while rotating the attracting nozzle (21) having the chip component (20) attracted thereto and on the basis of the detected rotation centre (O) of the attracting nozzle (21).

6. Apparatus for mounting chip components (20) at specific positions, preferably on a substrate such as a printed circuit board, comprising a movable head unit (5) supporting an attracting nozzle (21) for attracting a chip component by vacuum and transferring the same from a component supply side (4) to a component mounting side, said attracting nozzle (21) being rotatable, a main control unit (43) for controlling the mounting operation, optical detecting means (31) for detecting whether or not the attracting nozzle has a shape and/or a position adapted to the chip component to be mounted, and memory means (44) for storing external shape feature values of the attracting nozzle (21), **characterised by** rotation centre detecting means (54) for detecting the rotation centre ($N_{co}$) of the attracting nozzle (21) on the basis of position data ($N_c$) obtained from the optical detecting means (31) which is adapted to detect the projection of the attracting nozzle (21) while rotating the same in a detection area of said optical detecting means (31), memory means (45) for storing the rotation centre ($N_{co}$) of the attracting nozzle, and correcting means (55) for determining correction values for the component mounting position using said rotation centre ($N_{co}$) of the attracting nozzle (21) as the center position ($C_N$) of the attracting nozzle (21).

7. Apparatus as claimed in claim 6, **characterised in that** the optical detecting means (31) includes means for detecting the projection of the component (21) by parallel light beams emitted from a beam emitting portion (31a) and a light beam receiving portion (31b) provided on the head unit (5), the apparatus further comprising means (26) for raising or lowering the attracting nozzle (21), reference nozzle height detecting means for detecting the reference nozzle height, which is the nozzle height obtained when the tip end of the attracting nozzle (21) is brought to a position corresponding to the optical detecting means (31) provided on the head unit (5) by raising or lowering the attracting nozzle (21), a memory means for storing the reference nozzle height, discriminating means for evaluating the attracted state of the chip component (20) on the basis of the detection of the projected image of the chip component (20) made by the optical detecting means (31) after the chip component (20) is attracted by the attracting nozzle (21), and control means (40) for controlling the means (26) for raising or lowering the attracting nozzle (21) such that the attracting nozzle (21) is brought to a height obtained on the basis of the reference nozzle height read-out of the memory means (45) at the time of said evaluation.

8. Apparatus as claimed in claim 7, **characterised in that** said correction values are determined on the basis of the pre-stored correct rotation centre for said attracting nozzle (21) read-out of the memory means (45) and on the basis of the data obtained by detecting the projection of the chip component (20) by the optical detecting means (31) by rotating the attracting nozzle (21) having a chip component (20) attracted thereto.

## Patentansprüche

1. Verfahren zum Montieren von Chip-Bauteilen an bestimmten Positionen, bevorzugt auf einem Substrat wie eine gedruckte Leiterplatte, mit einem Hauptarbeitsablauf mit den Schritten:
Anziehen eines Bauteils (20) mittels einer Anziehungsdüse (21), die einer bewegbaren Kopfeinheit (5) zugeordnet ist, von einer Bauteil-Zuführeinheit (4), Überführen des Chip-Bauteils (20) und Montieren desselben an einer gewünschten Position, sowie mit einem vorbereitenden Düsenerfassungsverfahren, das dem Haupt-Montierarbeitsablauf vorausgeht und eine optische Erfassungseinrichtung (31) verwendet zum Erfassen, ob die Anziehungsdüse (21) eine Form- und/oder eine Position innehat, die geeignet ist, das Chip-Bauteil zu montieren, **dadurch gekennzeichnet, daß** in dem vorbereitenden Düsenerfassungsprozeß die Anziehungsdüse (21) in einem Erfassungsbereich der optischen Erfassungseinrichtung (31) gedreht wird, um Projektionsdaten ($N_C$) der Anziehungsdüse (21) zu erhalten, während die Düse gedreht wird, wobei ein Rotationsmittelpunkt ($N_{CO}$) der Anziehungsdüse (21) auf der Grundlage der Projektionsdaten ($N_C$) festgestellt wird und wobei in der Hauptsequenz der Montagerotation Korrekturwerte für die Montageposition der Bauteile festgelegt werden, unter Verwendung dieses Rotationsmittelpunktes ($N_{CO}$) als einer Mittelpunktposition der Anziehungsdüse (21).

2. Verfahren nach Anspruch 1, **dadurch gekennzeichnet, daß** die Form und/oder die Position der an der Kopfeinheit (5) befestigten Anziehungsdüse (21) externe Formmerkmalswerte aufweist, die an die Form des zu befestigenden Chip-Bauteils (21) angepaßt sind, womit entschieden wird, ob eine angebrachte bestimmte Anziehungsdüse (21) geeignet ist oder nicht durch Vergleichen des erfaßten Wertes der externen Formmerkmalswerte mit einem festgesetzten Wert, der die richtige Anziehungsdüse (21) angibt.

3. Verfahren nach Anspruch 1 oder 2, **dadurch gekennzeichnet, daß** eine Referenz-Düsenhöhe erfaßt wird, welche eine Düsenhöhe ist, die erhalten wird, wenn ein Spitzenende der Anziehungsdüse (21) durch Anheben oder Absenken der Anziehungsdüse (21) in eine Position gebracht worden ist, die derjenigen der an der Kopfeinheit (5) angeordneten optischen Erfassungseinrichtung (31) entspricht, wobei diese Referenzhöhe abgespeichert wird als ein Festsetzungsprozeß auf der Grundlage der Erfassung der Referenzhöhe der entsprechenden Anziehungsdüse (21), und wobei in einem Zustand, in dem die Anziehungsdüse (21) mit einem daran anhaftenden Chip-Bauteil (20) auf eine Höhe gesetzt wird, die erhalten worden ist auf der Grundlage dieser Referenzdüsenhöhe, eine Projektionsweite ($W_S$) des Chip-Bauteils (20) von diesen optischen Erfassungseinrichtungen (31) erfaßt wird, sowie der Zustand der Anhaftungsart des Bauteils an der Anziehungsdüse (21) ermittelt wird auf der Grundlage der erfaßten Projektionsweise ($W_S$) des Chip-Bauteils (20).

4. Verfahren nach Anspruch 3, **dadurch gekennzeichnet, daß** als ein Prozeß für die Ermittlung des Anhaftungszustandes des Chip-Bauteils (20) die Projektionsweite ($W_S$) des Chip-Bauelements (20) gemessen wird, während dieses Chip-Bauteil um einen bestimmten Drehwinkelbereich ($\theta_e$) gedreht wird zur Erfassung eines Minimumwertes ($W_{min}$) des an der Anziehungsdüse (21) anhaftenden Chip-Bauteils (20) sowie eines Rotationswinkels ($\theta_m$), der dem minimalen Wert der Projektionsweite ($W_{min}$) entspricht, und durch Werten des Anziehungszustandes des Bauteils (20) als fehlerhaft entweder, wenn der Minimumwert ($W_{min}$) der Projektionsweite geringer als ein unterer Grenzwert des Referenzwertes ist, welcher um eine vorbestimmte Größe kleiner festgesetzt ist, als die kürzere Seite des Chip-Bauteils (20), und/oder, wenn der Minimumwert ($W_{min}$) der Projektionsweite größer als ein höherer Grenzwert des Referenzwertes ist, welcher um eine vorbestimmte Größe größer als die längere Seite des Chip-Bauteils (20) festgelegt ist, und/oder, wenn der dem Minimumwert ($W_{min}$) der Projektionsweite entsprechende Rotationswinkel ($\theta_m$) sich außerhalb des vorbestimmten Drehwinkelbereiches ($\theta_e$) befindet.

5. Verfahren nach mindestens einem der vorangegangenen Ansprüche, **dadurch gekennzeichnet, daß** der Rotationsmittelpunkt (O) der Anziehungsdüsen (21) abgespeichert ist und daß die Korrekturwerte der Befestigungsposition der Chip-Bauteile in dem darauffolgenden Hauptarbeitsablauf daraufhin erhalten werden, auf der Grundlage der Projektion des Chip-Bauteils (20), die erfaßt wurde von den optischen Erfassungseinrichtungen (31) während die Anziehungsdüse (21) mit dem daran anhaftenden Chip-Bauteil (20) gedreht wird, und zwar auf der Grundlage des erfaßten Rotationsmittelpunktes (O) der Anziehungsdüse (21).

6. Vorrichtung von Chip-Bauteilen (20) an bestimmten Positionen, bevorzugt auf einem Substrat, wie z. B. einer gedruckten Leiterplatte, mit einer bewegbaren Kopfeinheit (5), die eine Anziehungsdüse (21) verlagert zum Anziehen eines Chip-Bauteils mittels Vakuum und zum Überführen desselben von einer Bauteil-Förderseite (4) zu einer Bauteil-Montageseite, wobei diese Anziehungsdüse (21) drehbar ist, einer Hauptsteuereinheit (41) zur Steuerung der Montageoperation, optischen Erfassungseinrichtungen (31) zur Erfassung, ob die Anziehungsdüse eine Form und/oder eine Position aufweist, die an das zu montierende Chip-Bauteil angepaßt ist, und mit Speichereinrichtungen (44) zum Ablegen externer Formmerkmalswerte der Anziehungsdüse (21), gekennzeichnet durch eine Rotationsmittelpunkt-Erfassungseinrichtung (54) zur Erfassung des Rotationsmittelpunktes ($N_{CO}$) der Anziehungsdüse (21) auf der Grundlage von Positionsdaten ($N_C$), welche erhalten werden von der optischen Erfassungseinrichtung (31), die dazu geeignet ist, die Projektion der Anziehungsdüse (21) zu erfassen, während diese in einem Erfassungsbereich dieser optischen Erfassungseinrichtung (31) gedreht wird, durch Speichereinrichtungen (50) zum Ablegen des Rotationsmittelpunktes ($N_{CO}$) der Anziehungsdüse, durch Korrektureinrichtungen (55) zur Festlegung von Korrekturwerten für die Montageposition des Bauteils unter Verwendung dieses Rotationsmittelpunktes ($N_{CO}$) der Anziehungsdüse (21) als eine Mittelpunktsposition ($C_N$) der Anziehungsdüse (21).

7. Vorrichtung nach Anspruch 6, **dadurch gekennzeichnet, daß** die optische Erfassungseinrichtung (31) eine Einrichtung umfaßt zur Erfassung der Projektion des Bauteils (21) mittels von einem Strahlemittierungsbereichen (31a) emittierten parallelen Lichtstrahlen, und wobei ein Empfangsbereich (31d) für Lichtstrahlen an der Kopfeinheit (5) angeordnet ist, wobei die Vorrichtung des weiteren folgendes umfaßt, Einrichtungen (26) zum Abheben oder Absenken der Anziehungsdüse (21), Referenzdüsenhöheerfassungseinrichtungen zur Erfassung der Referenzdüsenhöhe, welche die Düsenhöhe ist, die erhalten wird, wenn das Spitzenende der Anziehungsdüse (21) durch Anheben oder durch Absenken der Anziehungsdüse (21) in eine Position gebracht ist, die derjenigen der optischen Erfassungseinrichtungen (31) entspricht, die an der Kopfeinheit (5) angeordnet ist, eine Speichereinrichtung zum Ablegen der Referenzdüsenhöhe, Entscheidungseinrichtungen zum Festlegen des Anziehungszustandes des Chip-Bauteils (20) auf der Grundlage der von der optischen Erfassungseinrichtung (31) durchgeführten Erfassung des projizierten Bildes des Chip-Bauteils (20), nachdem das Chip-Bauteil (20) von der Anziehungsdüse (21) angezogen worden ist, und Steuereinrichtung (40) zur Steuerung der Einrichtungen (26) zum Anheben oder zum Absenken der Anziehungsdüse (21) derart, daß die Anziehungsdüse (21) auf eine Höhe gebracht wird, die erhalten wird auf der Grundlage der aus der Speichereinrichtung (45) zu der Zeit dieser Feststellung ausgelesenen Referenzdüsenhöhe.

8. Vorrichtung nach Anspruch 7, **dadurch gekennzeichnet, daß** diese Korrekturwerte festgelegt sind auf der Grundlage des aus der Speichereinrichtung (45) ausgelesenen und vorher abgespeicherten korrekten Rotationsmittelpunktes für diese Anziehungsdüse (21) und auf der Grundlage von Daten, die erhalten werden durch Erfassen der Projektion des Chip-Bauteils (20) durch die optische Erfassungseinrichtung (31) durch Rotieren der Anziehungsdüse (21) mit einem daran anhaftenden Chip-Bauteil.

**Revendications**

1. Procédé de montage de composants en forme de pastille (20) à des positions spécifiques, de préférence sur un substrat tel qu'une carte à circuit imprimé, comprenant une opération principale incluant les étapes d'attraction d'un composant (20) par l'intermédiaire d'une buse d'attraction (21) associée à une unité formant tête mobile (5) à partir d'une unité d'alimentation en composants (4), de transfert du composant en forme de pastille (20) et de montage de ce dernier à la position souhaitée, et un processus préparatoire de détection de buse précédant l'opération principale de montage et utilisant des moyens optiques de détection (31) pour détecter si la buse d'attraction (21) a ou non une forme et/ou une position adaptées au composant en forme de pastille à monter, caractérisé en ce que, dans le processus préparatoire de détection de buse, la buse d'attraction (21) est tournée dans une zone de détection desdits moyens optiques de détection (31) pour obtenir des données de projection ($N_C$) de la buse d'attraction (21) tout en tournant la buse, dans lequel un centre de rotation ($N_{CO}$) de la buse d'attraction (21) est déterminé sur la base désdites données de projection ($N_C$) et dans lequel, dans l'opération principale de montage suivante, des valeurs de correction pour la position de montage de composant sont déterminées en utilisant ledit centre de rotation ($N_{CO}$) en tant que position centrale ($C_N$) de la buse d'attraction (21).

2. Procédé selon la revendication 1, caractérisé en ce que la forme et/ou la position de la buse d'attraction (21) qui est installée sur l'unité formant tête (5) comprennent des valeurs de particularité de forme externe ajustées à la forme du composant en forme de pastille (21) à monter, dans lequel on décide si une certaine buse d'attraction (21) installée est une buse correcte ou non en comparant la valeur de détection des valeurs de particularité de forme externe à une valeur fixée indicative pour la buse d'attraction correcte (21).

3. Procédé selon la revendication 1 ou 2, caractérisé en ce qu'une hauteur de référence de buse, qui est une hauteur de buse obtenue quand une extrémité de bout de la buse d'attraction (21) est amenée à une position correspondant aux moyens optiques de détection (31) disposés sur l'unité formant tête (5) en élevant ou en abaissant la buse d'attraction (21), est détectée, dans lequel ladite hauteur de référence est stockée en tant que processus de paramétrage basé sur la détection de la hauteur de référence de la buse d'attraction respective (21) et, dans l'opération principale de montage suivante, après cela, dans un état où la buse d'attraction (21) a un composant en forme de pastille (20) attiré vers cette dernière et amené à une hauteur obtenue sur la base de ladite hauteur de référence de buse, une largeur de projection ($W_S$) du composant en forme de puce (21) est détectée par lesdits moyens optiques de détection (31) et l'état de l'attraction de la pastille vers la buse d'attraction (21) est décidé sur la base de la largeur de projection détectée ($W_S$) du composant en forme de pastille (20).

4. Procédé selon la revendication 3, caractérisé en ce que, en tant que processus pour décider de l'état attiré du composant en forme de pastille (20), la largeur de projection ($W_S$) du composant en forme de pastille (20) est mesurée tout en tournant le composant en forme de pastille d'une plage d'angle de rotation définie ($\theta_e$), en détectant une valeur minimale de largeur de projection ($W_{min}$) du composant en forme de pastille (20) attiré vers la buse d'attraction (21) et l'angle de rotation ($\theta_m$) correspondant à la valeur minimale de la largeur de projection ($W_{min}$), en évaluant l'état attiré du composant en forme de pastille (20) comme étant défectueux soit lorsque la valeur minimale de largeur de projection ($W_{min}$) est plus petite qu'une valeur de référence de limite inférieure qui est fixée comme étant plus petite d'une quantité prédéterminée que le côté plus court du composant en forme de pastille (20), et/ou lorsque la valeur minimale de largeur de projection ($W_{min}$) est plus grande qu'une valeur de référence de limite supérieure qui est fixée comme étant plus grande d'une quantité prédéterminée que le côté plus long du composant en forme de pastille (20), et/ou lorsque l'angle de rotation ($\theta_m$) correspondant à la valeur minimale de largeur de projection ($W_{min}$) est à l'extérieur de la plage d'angle de rotation définie prédéterminée ($\theta_e$).

5. Procédé selon au moins l'une des revendications précédentes 1 à 4, dans lequel le centre de rotation (O) de la buse d'attraction (21) est stocké et dans lequel les valeurs de correction de la position de montage du composant en forme de pastille, dans le processus principal suivant après cela, sont obtenues sur la base de la projection du composant en forme de pastille (20) détectée par les moyens optiques de détection (31) tout en tournant la buse d'attraction (21) ayant le composant en forme de pastille (20) attiré vers cette dernière et sur la base du centre de rotation détecté (O) de la buse d'attraction (21).

6. Appareil pour monter des composants en forme de pastille (20) à des positions spécifiques, de préférence sur un substrat tel qu'une carte à circuit imprimé, comprenant une unité formant tête mobile (5) supportant une buse d'attraction (21) pour attirer un composant en forme de pastille par aspiration et pour transférer ce dernier depuis un côté alimentation en composants (4) vers un côté montage de composants, ladite buse d'attraction (21) pouvant être mise en rotation, une unité principale de commande (43) pour commander l'opération de montage, des moyens optiques de détection (31) pour détecter si la buse d'attraction a ou non une forme et/ou une position adaptées au composant en forme de pastille à monter, et des moyens formant mémoire (44) pour stocker des valeurs de particularité de forme externe de la buse d'attraction (21), caractérisé par des moyens de détection de centre de rotation (54) pour détecter le centre de rotation ($N_{CO}$) de la buse d'attraction (21) sur la base de données de position ($N_C$) obtenues à partir des moyens optiques de détection (31) qui sont conçus pour détecter la projection de la buse d'attraction (21) tout en tournant cette dernière dans une zone de détection desdits moyens optiques de détection (31), des moyens formant mémoire (45) pour stocker le centre de rotation ($N_{CO}$) de la buse d'attraction, et des moyens de correction (55) pour déterminer des valeurs de correction pour la position de montage du composant en utilisant ledit centre de rotation ($N_{CO}$) de la buse d'attraction (21), en tant que position centrale ($C_N$) de la buse d'attraction (21).

7. Appareil selon la revendication 6, caractérisé en ce que les moyens optiques de détection (31) comprennent des moyens pour détecter la projection du composant (21) par des faisceaux parallèles de lumière émis à partir d'une partie d'émission de faisceau (31a) et une partie de réception de faisceau de lumière (31b) prévue sur l'unité formant tête (5), l'appareil comprenant, de plus, des moyens (26) pour élever ou abaisser la buse d'attraction (21), des moyens de détection de hauteur de référence de buse pour détecter la hauteur de référence de buse, qui est la hauteur de buse obtenue quand l'extrémité de bout de la buse d'attraction (21) est amenée à une position correspondant aux moyens optiques de détection (31) disposés sur l'unité formant tête (5) en élevant ou en abaissant la buse d'attraction (21), des moyens formant mémoire pour stocker la hauteur de référence de buse, des moyens de discrimination pour évaluer l'état attiré du composant en forme de pastille (20) sur la base de la détection de l'image projetée du composant en forme de pastille (20) effectuée par les moyens optiques de détection (31) après que le composant en forme de pastille (20) a été attiré par la buse d'attraction (21), et des moyens de commande (40) pour commander les moyens (26) pour élever ou pour abaisser la buse d'attraction (21) de sorte que la buse d'attraction (21) soit amenée à une hauteur obtenue sur la base de la hauteur de référence de buse lue dans les moyens formant mémoire (45) au moment de ladite évaluation.

8. Appareil selon la revendication 7, caractérisé en ce que lesdites valeurs de correction sont déterminées sur la base du centre de rotation correct préstocké pour ladite buse d'attraction (21) lu dans les moyens formant mémoire (45) et sur la base des données obtenues en détectant la projection du composant en forme de pastille (20) par les moyens optiques de détection (31) en faisant tourner la buse d'attraction (21) ayant un composant en forme de pastille (20) attiré vers cette dernière.

FIGURE 1

FIGURE 2

FIGURE 3

**FIGURE 4**

FIGURE 5

FIGURE 6

(a)

(b)

FIGURE 7

EP 0 582 171 B1

START

PRODUCING ATTRACTING VACUUM — S11

START TRANSFERRING IN X, Y AND θ AXES DIRECTIONS — S12

S13 — X Y θ WITHIN PREDETERMINED POSITIONAL RANGE ? — NO / YES

LOWERING HEAD — S14

LOWERING ATTRACTING NOZZLE — S15

ATTRACTING COMPONENT — S16

RAISING ATTRACTING NOZZLE — S17

RAISING HEAD — S18

S19 — ATTRACTING NOZZLE ESCAPED OUT OF INTER-FERENCE RANGE ? — NO / YES

TRANSFERRING HEAD UNIT TO MOUNTING POSITION — S20

RAISING ATTRACTING NOZZLE TO RECOGNIZING HEIGHT — S21

DETECTING Cs, Ws, θs — S22

DETECTING PROJECTION WIDTH ROTATING ATTRACTING NOZZLE — S23

A

S24 — ROTATED BY θe? — NO / YES

DETECTING Wmin, Cs, θs — S25

S26 — COMPONENT ATTRACTED NORMALLY ? — NO — S27 DISCARDING COMPONENT / YES

CALCULATING CORRECTION AMOUNTS Xc, Yc, θc — S28

TRANSFERRING HEAD UNIT TO MOUNTING POSITION AFTER CORRECTION — S29

S30 — G(X,Y,θ) WITHIN MOUNTING POSITION RANGE ? — NO / YES

LOWERING HEAD — S31

LOWERING ATTRACTING NOZZLE — S32

S33 — HEIGHT WITHIN PREDETERMINED POSITIONAL RANGE ? — NO / YES

CURRING OFF ATTRACTING VACUUM — S34

RAISING ATTRACTING NOZZLE — S35

RAISING HEAD — S36

END

FIGURE 8

22

**FIGURE 9**

(a)  (b)  (c)

**FIGURE 10**

FIGURE 11

FIGURE 12

FIGURE 13

FIGURE 14

START

**S41**

RAISING NOZZLE

**S42**

NOZZLE PROJECTION VANISHED ?

NO

**S43**

↓YES

STORING Z AXIS COORDINATE $Z_0$
AT THAT TIME AS REFERENCE
NOZZLE HEIGHT

END

FIGURE 15

(a)

5

31

31b       21       31a

(b)

5

31

31b       21       31a

**FIGURE 16**

5

21

H

20

**FIGURE 17**

START

S51

TRANSFERRING NOZZLE IN Z
AXIS DIRECTION

S52

NOZZLE TIP
END AT LASER HEIGHT
POSITION

NO

YES

S53

ROTATING NOZZLE (0 TO
360 DEGREES), MEASURING
AND STORING NOZZLE TIP
END CENTER Nc

S54

COMPARING Nc VALUES
OBTAINED, ATTRACTING
Ncmax AND Ncmin

S55

CALCULATING AND STORING
ROTATION CENTER Nco

END

FIGURE 18

FIGURE 19

FIGURE 20

FIGURE 21